(19) Europäisches Patentamt / European Patent Office / Office européen des brevets

(11) **EP 3 840 260 A1**

(12) **EUROPEAN PATENT APPLICATION**
published in accordance with Art. 153(4) EPC

(43) Date of publication:
**23.06.2021 Bulletin 2021/25**

(21) Application number: **18931878.5**

(22) Date of filing: **30.08.2018**

(51) Int Cl.:
**H04L 1/00** (2006.01)    **H03M 13/09** (2006.01)

(86) International application number:
**PCT/CN2018/103293**

(87) International publication number:
**WO 2020/042089 (05.03.2020 Gazette 2020/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(71) Applicant: **HUAWEI TECHNOLOGIES CO., LTD.**
**Shenzhen, Guangdong 518129 (CN)**

(72) Inventors:
• **MA, Liang**
  **Shenzhen, Guangdong 518129 (CN)**
• **LI, Hang**
  **Shenzhen, Guangdong 518129 (CN)**
• **WEI, Yuejun**
  **Shenzhen, Guangdong 518129 (CN)**

(74) Representative: **Epping - Hermann - Fischer**
**Patentanwaltsgesellschaft mbH**
**Schloßschmidstraße 5**
**80639 München (DE)**

(54) **SCL PARALLEL DECODING METHOD, APPARATUS, AND DEVICE**

(57) This application provides an SCL parallel decoding method and apparatus and a device. The method includes: after received data corresponds to P groups of to-be-decoded bits, obtaining $L_1$ first decoding paths of an $(i-1)^{th}$ group of to-be-decoded bits, where i is an integer, P is an integer greater than 1, $1 < i \leq P$, and $L_1$ is a positive integer; determining $L_3$ third decoding paths for each first decoding path, where a quantity of information bits in an $i^{th}$ group of to-be-decoded bits is n, n is a positive integer greater than or equal to 1, $L_3$ is a positive integer, and $L_3 < 2^n$; and determining at least one reserved decoding path of the $i^{th}$ group of to-be-decoded bits from $L_1 \times L_3$ third decoding paths, where the at least one reserved decoding path includes a decoding result of the $i^{th}$ group of to-be-decoded bits. In this way, SCL parallel decoding efficiency is improved.

Obtain $L_1$ first decoding paths of an $(i-1)^{th}$ group of to-be-decoded bits — S401

Determine $L_3$ third decoding paths for each first decoding path — S402

Determine at least one reserved decoding path from $L_1 * L_3$ third decoding paths — S403

FIG. 4

EP 3 840 260 A1

**Description**

**TECHNICAL FIELD**

This application relates to the field of communications technologies, and in particular, to an SCL parallel decoding method and apparatus and a device.

**BACKGROUND**

In the field of communications technologies, a communications device (for example, a terminal device or a base station) may perform channel coding and decoding by using a polar code (Polar code).

In the prior art, when decoding is performed by using the polar code, a process of performing decoding by using a parallel method based on a successive cancellation list (Successive Cancellation List, SCL) algorithm is usually as follows: dividing to-be-decoded bits into a plurality of groups of bits, and sequentially decoding each group of bits. Each time a group of bits is decoded, a plurality of decoding paths are obtained through extension, and a specific quantity of paths are reserved from the plurality of decoding paths for decoding a next group of bits. Finally, a plurality of decoding result paths may be obtained, a decoding path having a highest decoding accuracy rate is selected from the plurality of decoding paths, and a decoding result on the decoding path is used as decoding output.

However, in the foregoing method, decoding speed is slow and complexity is relatively high.

**SUMMARY**

This application provides an SCL parallel decoding method and apparatus and a device, to improve SCL parallel decoding efficiency.

According to a first aspect, this application provides an SCL parallel decoding method. After data received by a receiving device corresponds to P (where P is an integer greater than 1) groups of to-be-decoded bits, any $i^{th}$ (where i is an integer, and $1<i\leq P$) group in the P groups of to-be-decoded bits may be decoded in the following feasible implementation:

obtaining $L_1$ first decoding paths of an $(i-1)^{th}$ group of to-be-decoded bits; determining $L_3$ third decoding paths for each first decoding path; and determining at least one reserved decoding path of the $i^{th}$ group of to-be-decoded bits from $L_1 \times L_3$ third decoding paths, where the at least one reserved decoding path includes a decoding result of the $i^{th}$ group of to-be-decoded bits, where a quantity of information bits in the $i^{th}$ group of to-be-decoded bits is n (where n is a positive integer), and $L_3 < 2^n$.

In the foregoing process, in a process of determining the at least one reserved decoding path of the $i^{th}$ group of to-be-decoded bits, the $L_1 \times L_3$ third decoding paths need to be sorted, and the at least one reserved decoding path is selected from the $L_1 \times L_3$ sorted third decoding paths. Because $L_3 < 2^n$, sorting complexity can be reduced in the process of determining the at least one reserved decoding path of the $i^{th}$ group of to-be-decoded bits, thereby improving efficiency of the SCL parallel decoding method.

In a possible implementation, the $L_3$ third decoding paths may be determined for each first decoding path in the following feasible implementation: determining $L_2$ second decoding paths for each first decoding path; determining the $L_3$ third decoding paths from the $L_2$ second decoding paths corresponding to each first decoding path, where $L_2 = 2^n$.

In another possible implementation, $L_3 = 2^{m-k}$, where k is a positive integer, m is a quantity of to-be-decoded bits included in each group of to-be-decoded bits, m is an integer greater than 1, and $1 \leq k < m$.

Optionally, k may be a preset value.

Optionally, m may also be referred to as SCL parallel decoding parallelism.

In the foregoing process, when k is the preset value, $L_3$ is related to the SCL parallel decoding parallelism m. Different SCL parallel decoding parallelism m may indicate different $L_3$, thereby improving flexibility of determining $L_3$.

In another possible implementation, $L_3$ is any one of 2, 4, 8, 16, 32, or 64.

In another possible implementation, when i=P, the method further includes: determining, from the at least one reserved decoding path, a decoding path having a highest accuracy rate, and determining a decoding result of the P groups of to-be-decoded bits based on the decoding path.

According to a second aspect, this application provides an SCL parallel decoding method. Data received by a receiving device corresponds to P (where P is an integer greater than 1) groups of to-be-decoded bits. Any $i^{th}$ (where i is an integer, and $1<i\leq P$) group in the P groups of to-be-decoded bits may be decoded in the following feasible implementation:

obtaining $L_1$ first decoding paths of an $(i-1)^{th}$ group of to-be-decoded bits; determining $L_3$ third decoding paths for each first decoding path when a preset condition is met; and determining at least one reserved decoding path of the $i^{th}$ group of to-be-decoded bits from $L_1 \times L_3$ third decoding paths, where the at least one reserved decoding path includes a decoding result of the $i^{th}$ group of to-be-decoded bits, where $L_1 \times L_3$ is greater than or equal to a first preset threshold, a quantity of information bits in the $i^{th}$ group of to-be-decoded bits is n (where n is a positive integer), and $L_3 < 2^n$.

In the foregoing process, in a process of determining the at least one reserved decoding path of the $i^{th}$ group of to-be-decoded bits, the $L_1 \times L_3$ third decoding paths need to be sorted, and the at least one reserved decoding path is selected from the $L_1 \times L_3$ sorted third decoding paths. Because $L_3 < 2^n$, sorting complexity can be reduced in the process of determining the at least one reserved decoding path of the $i^{th}$ group of to-be-decoded bits, thereby improving efficiency of the SCL parallel decoding method.

In a possible implementation, the $L_3$ third decoding paths may be determined for each first decoding path in the following feasible implementation: determining $L_2$ second decoding paths for each first path; determining the $L_3$ third decoding paths from the $L_2$ second decoding paths corresponding to each first decoding path, where $L_2 = 2^n$. In another possible implementation, the preset condition is: $L_1 \times L_2$ is greater than the first preset threshold. When $L_1 \times L_2$ is greater than the first preset threshold, the $L_3$ third decoding paths are determined for each first decoding path, and the at least one reserved decoding path of the $i^{th}$ group of to-be-decoded bits is determined from the $L_1 \times L_3$ third decoding paths. In this way, not only can sorting complexity be reduced, but also loss of decoding performance can be smaller.

In another possible implementation, the first preset threshold is any one of 2, 4, 8, 16, 32, 64, or 128.

In another possible implementation, if $L_1 \times 2^{m-k}$ is greater than or equal to the first preset threshold, $L_3 = 2^{m-k}$, where k is a positive integer, m is a quantity of to-be-decoded bits included in each group of to-be-decoded bits, m is an integer greater than 1, and $1 \leq k < m$.

Optionally, k may be a preset value.

Optionally, m may also be referred to as SCL parallel decoding parallelism.

In the foregoing process, when k is the preset value, $L_3$ is related to the SCL parallel decoding parallelism m. Different SCL parallel decoding parallelism m may indicate different $L_3$, thereby improving flexibility of determining $L_3$.

In another possible implementation, $L_3$ is any one of 2, 4, 8, 16, 32, or 64.

In another possible implementation, when i=P, the method further includes: determining, from the at least one reserved decoding path, a decoding path having a highest accuracy rate, and determining a decoding result of the P groups of to-be-decoded bits based on the decoding path.

According to a third aspect, this application provides an SCL parallel decoding apparatus. Received data corresponds to P groups of to-be-decoded bits, and the apparatus includes an obtaining module, a first determining module, and a second determining module, where

the obtaining module is configured to obtain $L_1$ first decoding paths of an $(i-1)^{th}$ group of to-be-decoded bits, where i is an integer, P is an integer greater than 1, $1 < i \leq P$, and $L_1$ is a positive integer;

the first determining module is configured to determine $L_3$ third decoding paths for each first decoding path, where a quantity of information bits in an $i^{th}$ group of to-be-decoded bits is n, n is a positive integer greater than or equal to 1, $L_3$ is a positive integer, and $L_3 < 2^n$; and

the second determining module is configured to determine at least one reserved decoding path of the $i^{th}$ group of to-be-decoded bits from $L_1 \times L_3$ third decoding paths, where the at least one reserved decoding path includes a decoding result of the $i^{th}$ group of to-be-decoded bits.

In a possible implementation, the first determining module is specifically configured to:

determine $L_2$ second decoding paths for each first decoding path, where $L_2 = 2^n$; and
determine the $L_3$ third decoding paths from the $L_2$ second decoding paths corresponding to each first decoding path.

In another possible implementation, $L_3 = 2^{m-k}$, where k is a positive integer, m is a quantity of to-be-decoded bits included in each group of to-be-decoded bits, m is an integer greater than 1, and $1 \leq k < m$.

In another possible implementation, $L_3$ is any one of 2, 4, 8, 16, 32, or 64.

In another possible implementation, the apparatus further includes a third determining module, where

the third determining module is configured to: when i=P, determine, from the at least one reserved decoding path, a decoding path having a highest accuracy rate, and determine a decoding result of the P groups of to-be-decoded bits based on the decoding path.

According to a fourth aspect, this application provides an SCL parallel decoding apparatus. Received data corresponds to P groups of to-be-decoded bits, and the apparatus includes an obtaining module, a first determining module, and a second determining module, where

the obtaining module is configured to obtain $L_1$ first decoding paths of an $(i-1)^{th}$ group of to-be-decoded bits, where i is an integer, P is an integer greater than 1, $1 < i \leq P$, and $L_1$ is a positive integer;

the first determining module is configured to determine $L_3$ third decoding paths for each first decoding path when a preset condition is met, where $L_1 \times L_3$ is greater than or equal to a first preset threshold, a quantity of information bits in an $i^{th}$ group of to-be-decoded bits is n, n is a positive integer greater than or equal to 1, $L_3$ is a positive integer, and $L_3 < 2^n$; and

the second determining module is configured to determine at least one reserved decoding path of the $i^{th}$ group of to-be-

decoded bits from $L_1 \times L_3$ third decoding paths, where the at least one reserved decoding path includes a decoding result of the $i^{th}$ group of to-be-decoded bits.

In a possible implementation, the first determining module is specifically configured to:

determine $L_2$ second decoding paths for each first path, where $L_2 = 2^n$; and
determine the $L_3$ third decoding paths from the $L_2$ second decoding paths corresponding to each first decoding path.

In another possible implementation, the preset condition is:
$L_1 \times L_2$ is greater than the first preset threshold. 19. The apparatus according to any one of claims 16 to 18, where the first preset threshold is any one of 2, 4, 8, 16, 32, 64, or 128.

In another possible implementation, if $L_1 \times 2^{m-k}$ is greater than or equal to the first preset threshold, $L_3 = 2^{m-k}$, where k is a positive integer, m is a quantity of to-be-decoded bits included in each group of to-be-decoded bits, m is an integer greater than 1, and $1 \leq k < m$.

In another possible implementation, $L_3$ is any one of 2, 4, 8, 16, 32, or 64.

In another possible implementation, the apparatus further includes a third determining module, where the third determining module is configured to: when i=P, determine, from the at least one reserved decoding path, a decoding path having a highest accuracy rate, and determine a decoding result of the P groups of to-be-decoded bits based on the decoding path.

According to a fifth aspect, this application provides an SCL parallel decoding apparatus. The SCL parallel decoding apparatus includes a memory and a processor. The processor executes a program instruction in the memory, to implement the SCL parallel decoding method according to any one of the first aspect.

According to a sixth aspect, this application provides an SCL parallel decoding apparatus. The SCL parallel decoding apparatus includes a memory and a processor. The processor executes a program instruction in the memory, to implement the SCL parallel decoding method according to any one of the second aspect.

According to a seventh aspect, this application provides a storage medium. The storage medium is configured to store a computer program, and the computer program is used to implement the SCL parallel decoding method according to any one of the first aspect.

According to a seventh aspect, this application provides a storage medium. The storage medium is configured to store a computer program, and the computer program is used to implement the SCL parallel decoding method according to any one of the second aspect.

According to the SCL parallel decoding method and apparatus and a device provided in this application, after the received data corresponds to the P (where P is an integer greater than 1) groups of to-be-decoded bits, for any $i^{th}$ (where i is an integer, and $1<i\leq P$) group in the P groups of to-be-decoded bits, the $L_1$ first decoding paths of the $(i-1)^{th}$ group of to-be-decoded bits are first obtained; the $L_3$ third decoding paths are determined for each first decoding path; and the at least one reserved decoding path of the $i^{th}$ group of to-be-decoded bits is determined from the $L_1 \times L_3$ third decoding paths, where the at least one reserved decoding path includes the decoding result of the $i^{th}$ group of to-be-decoded bits, where the quantity of information bits in the $i^{th}$ group of to-be-decoded bits is n (where n is a positive integer), and $L_3 < 2^n$. In the foregoing process, in the process of determining the at least one reserved decoding path of the $i^{th}$ group of to-be-decoded bits, the $L_1 \times L_3$ third decoding paths need to be sorted, and the at least one reserved decoding path is selected from the $L_1 \times L_3$ sorted third decoding paths. Because $L_3 < 2^n$, the sorting complexity can be reduced in the process of determining the at least one reserved decoding path of the $i^{th}$ group of to-be-decoded bits, thereby improving the efficiency of the SCL parallel decoding method.

## BRIEF DESCRIPTION OF DRAWINGS

FIG. 1 is an architectural diagram of a communications system according to this application;
FIG. 2 is a schematic flowchart of an SCL parallel decoding method according to this application;
FIG. 2A is a schematic diagram of a decoding path according to this application;
FIG. 3 is a schematic flowchart of another SCL parallel decoding method according to this application;
FIG. 4 is a schematic flowchart of still another SCL parallel decoding method according to this application;
FIG. 5 is a schematic diagram of an SCL parallel decoding process according to this application;
FIG. 6 is a schematic flowchart of yet another SCL parallel decoding method according to this application;
FIG. 7 is a schematic flowchart of another SCL parallel decoding method according to this application;
FIG. 8A is a schematic diagram of first-step decoding of SCL parallel decoding according to this application;
FIG. 8B is a schematic diagram of second-step decoding of SCL parallel decoding according to this application;
FIG. 8C is a schematic diagram of third-step decoding of SCL parallel decoding according to this application;

FIG. 8D is a schematic diagram of fourth-step decoding of SCL parallel decoding according to this application;

FIG. 9 is a schematic structural diagram of an SCL parallel decoding apparatus according to this application;

FIG. 10 is a schematic structural diagram of another SCL parallel decoding apparatus according to this application;

FIG. 11 is a schematic structural diagram of still another SCL parallel decoding apparatus according to this application;

FIG. 12 is a schematic structural diagram of another SCL parallel decoding apparatus according to this application; and

FIG. 13 is a schematic structural diagram of hardware of an SCL parallel decoding apparatus according to this application.

## DESCRIPTION OF EMBODIMENTS

Embodiments of this application may be used in various fields in which polar coding is used, for example, a data storage field, an optical network communications field, and a wireless communications field. A wireless communications system mentioned in the embodiments of this application includes but is not limited to a narrowband internet of things (Narrow Band-Internet of Things, NB-IoT) system, Wimax, a long term evolution (Long Term Evolution, LTE) system, and three major application scenarios: an enhanced mobile broadband (enhanced Mobile Broad Band, eMBB) scenario, an ultra-reliable low-latency communication (ultra Reliable Low Latency Communication, URLLC) scenario, and a massive machine-type communications (massive Machine-Type Communications, mMTC) scenario, of a next-generation 5G mobile communications system, namely, a new radio (new radio, NR) system. Certainly, there may be another field in which polar coding is used. This is not specifically limited in this application.

A communications apparatus in this application is mainly a network device or a terminal device. In this application, a sending device may be a network device, and a receiving device is a terminal device. In this application, if a sending device is a terminal device, a receiving device is a network device.

In the embodiments of this application, the terminal device (terminal device) includes but is not limited to a mobile station (Mobile Station, MS), a mobile terminal (Mobile Terminal, MT), a mobile telephone (Mobile Telephone, MT), a handset (handset), portable equipment (portable equipment), and the like. The terminal device may communicate with one or more core networks by using a radio access network (Radio Access Network, RAN). For example, the terminal device may be a mobile telephone (or referred to as a "cellular" telephone) or a computer having a wireless communication function. The terminal device may alternatively be a portable, pocket-sized, handheld, computer built-in, or in-vehicle mobile apparatus or device.

The embodiments are described with reference to the network device in this application. The network device may be an evolved NodeB (Evolutional Node B, eNB or eNodeB) in an LTE system, or may be a gNB, a transmission reception point (transmission reception point, TRP), a micro base station, or the like in a 5G communications system, or may be a relay station, an access point, a vehicle-mounted device, a wearable device, a network device in a future evolved public land mobile network (Public Land Mobile Network, PLMN), a network device in a network in which a plurality of other technologies are converged, a base station in various other evolved networks, or the like.

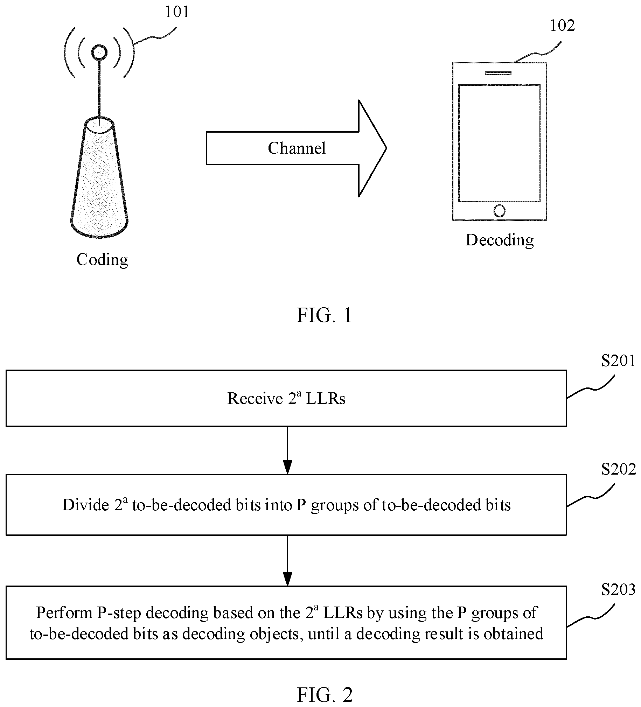

FIG. 1 is an architectural diagram of a communications system according to this application. Referring to FIG. 1, the communications system includes a sending device 101 and a receiving device 102.

Optionally, when the sending device 101 is a terminal device, the receiving device 102 is a network device; or when the sending device 101 is a network device, the receiving device is a terminal device.

Referring to FIG. 1, the sending device 101 includes an encoder, so that the sending device 101 can perform polar coding and output an encoded sequence. After rate matching, interleaving, and modulation, the encoded sequence is transmitted to the receiving device 102 on a channel. The receiving device 102 includes a decoder, so that the receiving device 102 can receive a signal sent by the sending device 101, and decode the received signal

It should be noted that FIG. 1 is merely an example of an architectural diagram of a communications system, and is not a limitation on the architectural diagram of the communications system.

In a communication process, a transmit end encodes an information bit and a frozen bit, to obtain a to-be-sent bit sequence, and sends the to-be-sent bit sequence. Optionally, the frozen bit is a padding bit, and the frozen bit may usually be 0. After rate matching, interleaving, and modulation, the to-be-sent bit sequence is transmitted to a receive end on a channel. The receive end performs processing such as demodulation on the received signal, to obtain a group of log likelihood ratios (Likelihood Rate, LLR), where a quantity of LLRs included in the group of LLRs is the same as a quantity of bits included in the to-be-sent bit sequence. The receive end performs polar code decoding based on the received group of LLRs. The receive end may make a misjudgment regardless of whether the transmit end sends a bit 1 or a bit 0. For a transmit b, at the receive end, a ratio of a probability $p(r|b=0)$ that a signal r is correctly determined as 0 to a probability $p(r|b=1)]$ that a signal r is correctly determined as 1 is a likelihood ratio. For ease of calculation and processing, a natural log is used for the likelihood ratio, so that a log likelihood ratio, that is, $LLR=\ln[p(r|b=0)/p(r|b=1)]$, can be obtained. The LLR may be a floating-point number.

The following describes in detail an SCL parallel decoding method shown in this application by using specific embodiments. It should be noted that the following several embodiments may be combined with each other, and same or similar content is not described repeatedly in different embodiments.

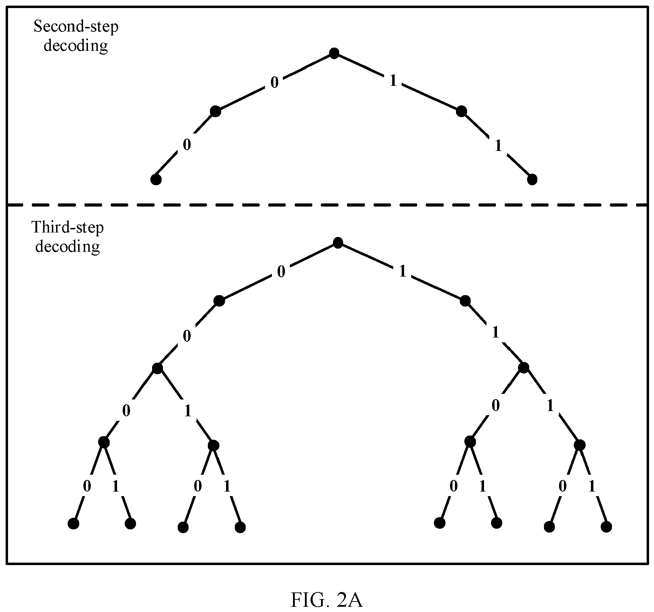

FIG. 2 is a schematic flowchart of an SCL parallel decoding method according to this application. Referring to FIG. 2, the method may include the following steps.

S201: Obtain $2^a$ LLRs, where

a is a positive integer greater than or equal to 1.

Optionally, a receiving device receives information, and then demodulates the information, to obtain the $2^a$ LLRs. Optionally, a quantity of LLRs obtained by the receiving device is the same as a quantity of bits sent by a sending device.

For example, assuming that a to-be-sent bit sequence sent by the sending device includes $2^a$ bits, the receiving device obtains the $2^a$ LLRs.

Optionally, a quantity of LLRs obtained by the receiving device is the same as a quantity of bits to be decoded by the receiving device.

For example, assuming that the receiving device obtains the $2^a$ LLRs, the receiving device needs to decode $2^a$ bits. A decoder in the receiving device uses the $2^a$ LLRs as input for decoding.

S202: Divide $2^a$ to-be-decoded bits into P groups of to-be-decoded bits, where

each group of to-be-decoded bits includes m bits, $2^a = P \times m$, P is a positive integer greater than 1, and m is a positive integer greater than or equal to 1.

Optionally, each group of to-be-decoded bits includes a to-be-decoded information bit and/or a to-be-decoded frozen bit, and the groups of to-be-decoded bits may include a same quantity of to-be-decoded information bits or different quantities of to-be-decoded information bits.

Optionally, the quantity m of bits included in each group of to-be-decoded bits may also be referred to as SCL parallel decoding parallelism.

For example, assuming that a quantity of to-be-decoded bits is 16 (that is, $2^4$), the to-be-decoded bits may be divided into P=4 groups, and each group of to-be-decoded bits includes four to-be-decoded bits.

S203: Perform P-step decoding based on the $2^a$ LLRs by using the P groups of to-be-decoded bits as decoding objects, until a decoding result is obtained.

Optionally, a decoding result (decoding path) corresponding to first i groups of to-be-decoded bits may be obtained through $i^{th}$-step decoding in the P-step decoding, where i is an integer greater than or equal to 1 and less than or equal to P. This may be implemented by performing the following step A to step C.

Step A: Calculate an $(m+1)^{th}$-layer LLR of each to-be-decoded information bit in an $i^{th}$ group of to-be-decoded bits based on the $2^a$ LLRs, where

a polar code butterfly decoding network includes a+1 columns of LLRs, and the $(m+1)^{th}$-layer LLR is an LLR located in an $(m+1)^{th}$ column from left to right in the polar code butterfly decoding network.

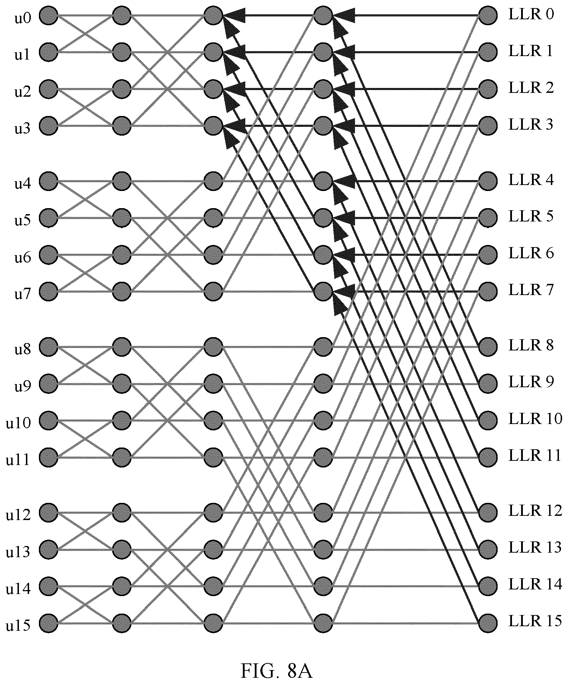

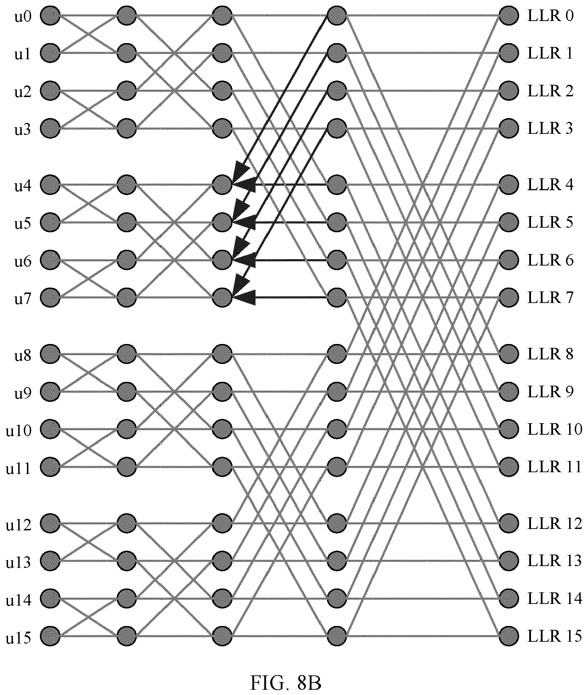

For example, referring to FIG. 8A and FIG. 8B, the quantity of to-be-decoded bits is $2^4$, and the polar code butterfly decoding network includes 4+1=5 columns of LLRs. The $(m+1)^{th}$-layer LLR is the LLR located in the $(m+1)^{th}$ column from left to right in the polar code butterfly decoding network.

Step B: Calculate, in parallel based on the $(m+1)^{th}$-layer LLR of each information bit in the $i^{th}$ group of to-be-decoded bits, path metric values of all possible decoding paths in the $i^{th}$-step decoding.

Optionally, an LLR of each information bit in the $i^{th}$ group of to-be-decoded bits may be calculated in parallel by using a maximum likelihood (Maximum Likelihood, ML) algorithm or a simplified (simplify) successive cancellation (Successive Cancellation, SC) algorithm, and then the path metric values of all the possible decoding paths in the $i^{th}$-step decoding are calculated in parallel based on the LLR of each information bit in the $i^{th}$ group of to-be-decoded bits. Optionally, a path metric value of a decoding path indicates a probability that the decoding path is a real decoding path.

Optionally, a smaller path metric value of a decoding path indicates a higher probability that the decoding path is a real decoding path.

Optionally, a path metric value of a decoding path may be calculated according to the following Formula 1:

$$PM_{ml} = \sum_{j=0}^{m} 1 + e^{-(1-2\hat{u}_{jl})\alpha_{jl}} \quad \text{Formula 1},$$

where

l represents an index of a decoding path, m is a quantity of bits included in a current path, $\hat{u}_{jl}$ is a decoding result (0 or 1) obtained by decoding a $j^{th}$ bit in the decoding path l, and $\alpha_{jl}$ is an LLR of the $j^{th}$ bit in the decoding path l.

When i is greater than 1, all the possible decoding paths in the $i^{th}$-step decoding may be determined based on a decoding path obtained through $(i-1)^{th}$-step decoding and a quantity n of information bits included in the $i^{th}$ group of to-be-decoded bits.

With reference to FIG. 2A, the following describes in detail all the possible decoding paths in the $i^{th}$-step decoding.

FIG. 2A is a schematic diagram of a decoding path according to this application. Referring to FIG. 2A, it is assumed that decoding paths obtained through second-step decoding are 00 and 11.

During third-step decoding, assuming that the third group of to-be-decoded bits includes two information bits, all possible decoding paths in the third-step decoding include $2^2$ decoding paths (0000, 0001, 0010, and 0011) obtained by extending the path 00 and $2^2$ decoding paths (1100, 1101, 1110, and 1111) obtained by extending the path 11. In other words, all the possible decoding paths in the third-step decoding include 0000, 0001, 0010, 0011, 1100, 1101, 1110, and 1111.

Step C: Select at least one reserved decoding path based on the path metric values of all the possible decoding paths.

Optionally, a quantity of reserved decoding paths is less than or equal to X, where

X is a quantity that is of reserved paths and that corresponds to the SCL parallel decoding method.

Optionally, the quantity X of reserved paths may be 4, 8, 16, or the like, and may be set based on an actual requirement. It should be noted that, if a quantity of all possible decoding paths is greater than or equal to X, the quantity of reserved decoding paths is equal to X; or if a quantity of all possible decoding paths is less than X, the quantity of reserved decoding paths is less than X and is equal to the quantity of all possible decoding paths.

Optionally, when i is greater than 1, a decoding result in the $(i-1)^{th}$-step decoding needs to be used in the $i^{th}$-step decoding.

For example, after first-step decoding, a plurality of reserved decoding paths in the first-step decoding may be obtained. The second-step decoding is performed based on the plurality of reserved decoding paths in the first-step decoding, to obtain a plurality of reserved decoding paths in the second-step decoding; the third-step decoding is performed based on the plurality of reserved decoding paths in the second-step decoding, to obtain a plurality of reserved decoding paths in the third-step decoding; and so on, until the P-step decoding is completed.

Optionally, when the $i^{th}$-step decoding is completed, reserved decoding paths obtained through the $i^{th}$-step decoding are decoding paths corresponding to the first to the $i^{th}$ groups of to-be-decoded bits. The decoding paths may be possible values of the first to the $i^{th}$ groups of to-be-decoded bits.

For example, it is assumed that a receive end receives 16 LLRs. Correspondingly, the quantity of to-be-decoded bits is 16, and the 16 to-be-decoded bits are respectively denoted as u0, u1, ..., and u15. It is assumed that all the 16 to-be-decoded bits are to-be-decoded information bits. It is assumed that the 16 to-be-decoded bits are divided into four groups, each group of to-be-decoded bits includes four to-be-decoded bits, and to-be-decoded bits included in the four groups of to-be-decoded bits are shown in Table 1.

Table 1

| First group of to-be-decoded bits | u0, u1, u2, and u3 |
|---|---|
| Second group of to-be-decoded bits | U4, u5, u6, and u7 |
| Third group of to-be-decoded bits | U8, u9, u10, and u11 |
| Fourth group of to-be-decoded bits | U12, u13, u14, and u15 |

After the first-step decoding is completed, the reserved decoding paths obtained through the first-step decoding are decoding paths corresponding to the first group of to-be-decoded bits u0 to u3. A length of the plurality of decoding paths in the first-step decoding is 4. For example, the plurality of reserved decoding paths in the first-step decoding may be 0000, 0001, 0010, and 0011.

After the second-step decoding is completed, the reserved decoding paths obtained through the second-step decoding are decoding paths corresponding to the first and the second groups of to-be-decoded bits u0 to u7. A length of the plurality of decoding paths in the second-step decoding is 8. For example, the plurality of reserved decoding paths in the second-step decoding may be 00000000, 00000001, and 00000010.

After the third-step decoding is completed, the reserved decoding paths obtained through the third-step decoding are decoding paths corresponding to the first to the third groups of to-be-decoded bits u0 to u11. A length of the plurality of decoding paths in the third-step decoding is 12. For example, the plurality of reserved decoding paths in the third-step decoding may be 000000000000, 000000000001, and 000000000010.

After fourth-step decoding is completed, reserved decoding paths obtained through the fourth-step decoding are decoding paths corresponding to the first to the fourth groups of to-be-decoded bits u0 to u15. A length of the plurality of decoding paths in the fourth-step decoding is 16. For example, the plurality of reserved decoding paths in the fourth-step decoding may be 0000000000000000 and 0000000000000001.

Therefore, one decoding path may be selected from the plurality of reserved decoding paths obtained through the fourth-step decoding as the decoding result. For example, the foregoing description is used as an example, and the selected decoding path is 0000000000000001. In other words, the decoding result of the 16 bits u0 to u15 is 0000000000000001.

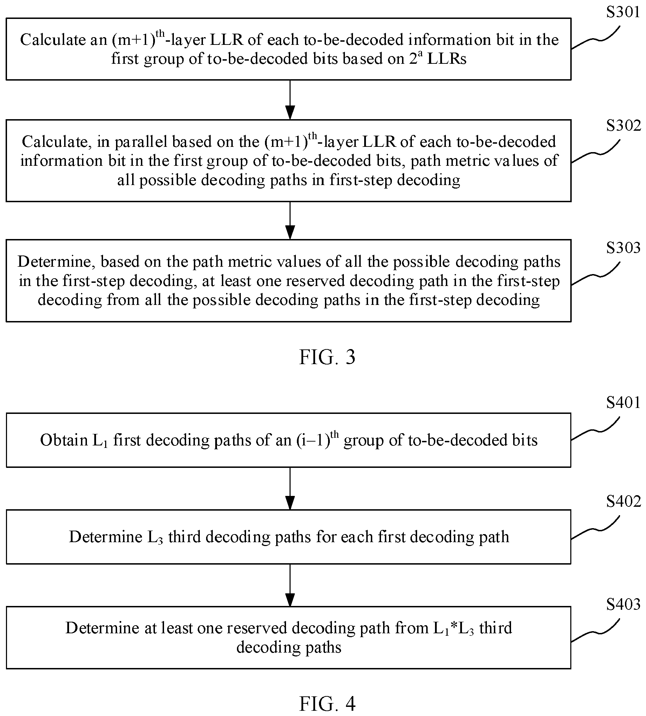

The following separately describes in detail a process of the first-step decoding and a process of the $i^{th}$-step decoding ($2 \leq i \leq P$). For details, refer to embodiments shown in FIG. 3 and FIG. 4.

FIG. 3 is a schematic flowchart of another SCL parallel decoding method according to this application. The embodiment shown in FIG. 3 is a process of first-step decoding of SCL parallel decoding. Referring to FIG. 3, the method may include the following steps.

S301: Calculate an $(m+1)^{th}$-layer LLR of each to-be-decoded information bit in the first group of to-be-decoded bits based on $2^a$ LLRs.

S302: Calculate, in parallel based on the $(m+1)^{th}$-layer LLR of each to-be-decoded information bit in the first group of to-be-decoded bits, path metric values of all possible decoding paths in the first-step decoding.

Optionally, an LLR of each information bit in the first group of to-be-decoded bits may be calculated in parallel by using an ML algorithm or a simplified SC algorithm, and then the path metric values of all the possible decoding paths in the first-step decoding are calculated in parallel based on the LLR of each information bit in the first group of to-be-decoded bits.

For example, assuming that the first group of to-be-decoded bits includes two information bits, all the possible decoding paths in the first-step decoding include $2^2$ decoding paths: 00, 01, 10, and 11.

For example, assuming that the first group of to-be-decoded bits includes four information bits, all the possible decoding paths in the first-step decoding include $2^4$ decoding paths: 0000, 0001, 0010, 0011, 0100, 0101, 0110, 0111, 1000, 1001, 1010, 1011, 1100, 1101, 1110, and 1111.

S303: Determine, based on the path metric values of all the possible decoding paths in the first-step decoding, at least one reserved decoding path of the first group of to-be-decoded bits from all the possible decoding paths in the first-step decoding.

Optionally, the reserved decoding path of the first group of to-be-decoded bits may also be referred to as a first decoding path of the first group of to-be-decoded bits, or may be referred to as a reserved decoding path in the first-step decoding or a first decoding path in the first-step decoding.

Optionally, a quantity of reserved decoding paths in the first-step decoding is less than or equal to X, where X is a quantity that is of reserved paths and that corresponds to the SCL parallel decoding method.

Optionally, the quantity X of reserved paths may be 4, 8, 16, or the like, and may be set based on an actual requirement. It should be noted that, if a quantity of all possible decoding paths in the first-step decoding is greater than or equal to X, X reserved decoding paths may be selected from all the possible decoding paths in the first-step decoding. In this case, the quantity of reserved decoding paths in the first-step decoding is equal to X. If a quantity of all possible decoding paths in the first-step decoding is less than X, all the possible decoding paths in the first-step decoding are determined as the reserved decoding paths in the first-step decoding. In this case, the quantity of reserved decoding paths obtained through the first-step decoding is less than X.

Optionally, a smaller path metric value of a decoding path indicates a higher probability that the decoding path is a real decoding path. In this case, if the quantity of all possible decoding paths in the first-step decoding is greater than X, the X reserved decoding paths may be selected in the following feasible implementation: determining, from all the possible decoding paths in the first-step decoding, X decoding paths having smallest path metric values as the X reserved decoding paths.

FIG. 4 is a schematic flowchart of still another SCL parallel decoding method according to this application. The embodiment shown in FIG. 4 is a process of any $i^{th}$-step decoding ($1 < i \leq P$) of SCL parallel decoding. Referring to FIG. 4, the method may include the following steps.

S401: Obtain $L_1$ first decoding paths of an $(i-1)^{th}$ group of to-be-decoded bits, where received data corresponds to P groups of to-be-decoded bits, $1 < i \leq P$, P is an integer greater than 1, i is an integer, and $L_1$ is a positive integer.

Optionally, $L_1 \leq X$.

For example, when X is 8, $L_1$ may be 2, 4, or 8.

It should be noted the $L_1$ first decoding paths of the $(i-1)^{th}$ group of to-be-decoded bits are reserved decoding paths of the $(i-1)^{th}$ group of to-be-decoded bits.

It should be noted that, in the SCL parallel decoding method, decoding needs to be performed step by step. To be specific, first-step decoding is performed, to obtain a first decoding path (reserved decoding path) in the first-step decoding; then second-step decoding is performed based on the first decoding path in the first-step decoding, to obtain a first decoding path in the second-step decoding; then third-step decoding is performed based on the first decoding path in the second-step decoding, to obtain a first decoding path in the third-step decoding; and so on. Therefore, when $i^{th}$-step decoding is performed, $L_1$ first decoding paths in $(i-1)^{th}$-step decoding have been obtained.

Optionally, after the $L_1$ first decoding paths in the $(i-1)^{th}$-step decoding are obtained, the $L_1$ first decoding paths may be buffered. Correspondingly, during the $i^{th}$-step decoding, the $L_1$ first decoding paths may be directly obtained from the buffer.

S402: Determine $L_3$ third decoding paths for each first decoding path, where
a quantity of information bits in an $i^{th}$ group of to-be-decoded bits is n, $L_3$ is a positive integer, and $L_3 < 2^n$.

Optionally, the $L_3$ third decoding paths may be determined for each first decoding path by performing the following step A and step B.

Step A: Determine $L_2$ second decoding paths for each first decoding path, where $L_2 = 2^n$.

Optionally, for any first decoding path, $L_2$ second decoding paths corresponding to the first decoding path may be determined based on the first decoding path and the quantity n of information bits included in the $i^{th}$ group of to-be-decoded bits.

For example, assuming that a first decoding path is 0010, and n is 2, it may be determined that $L_2 = 2^2 = 4$ second decoding paths corresponding to the first decoding path 0010 include 001000, 001001, 001010, and 001011.

Step B: Determine the $L_3$ third decoding paths from the $L_2$ second decoding paths corresponding to each first decoding path.

It should be noted that, $L_3$ may be obtained before step B is performed, and S403 is performed only when $L_2 > L_3$. When $L_2 \leq L_3$, step B does not need to be performed. Correspondingly, in S403, the at least one reserved decoding path can be directly determined from $L_1 \times L_2$ second decoding paths.

Optionally, $L_3$ may be obtained in at least the following two feasible implementations.

In a feasible implementation, $L_3$ may be a preset value.

In this feasible implementation, $L_3$ is the preset value, and preset $L_3$ may be pre-stored. Correspondingly, when $L_3$ needs to be used, $L_3$ only needs to be directly obtained.

For example, $L_3$ may be any one of 2, 4, 8, 16, 32, or 64.

Certainly, in an actual application process, a value of $L_3$ may be set based on an actual requirement. This is not specifically limited in this application.

In another feasible implementation, $L_3$ is determined based on SCL decoding parallelism.

The SCL decoding parallelism refers to a quantity of bits included in a group of to-be-decoded bits in SCL parallel decoding.

Optionally, $L_3 = 2^{m-k}$, where m is the SCL parallel decoding parallelism, k is a positive integer, m is a positive integer, and $1 \leq k < m$.

It should be noted that the foregoing merely shows, in a form of an example, a method for determining $L_3$, and does not limit the method for determining $L_3$. In an actual application process, $L_3$ may be determined based on an actual requirement. This is not specifically limited in this application.

Optionally, the $L_3$ third decoding paths are $L_3$ decoding paths having highest probabilities that the $L_2$ second decoding paths are real decoding paths.

Optionally, the $L_2$ second decoding paths may be sorted based on path metric values of the $L_2$ second decoding paths, and the $L_3$ third decoding paths are selected from the $L_2$ sorted second decoding paths.

For example, a smaller path metric value of a decoding path indicates a higher probability that the decoding path is a real decoding path. In this case, $L_3$ decoding paths having smallest path metric values may be determined from the $L_2$ second decoding paths as the $L_3$ third decoding paths.

Because the $L_3$ third decoding paths may be determined from the $L_2$ second decoding paths corresponding to each first decoding path, a total of $L_1 \times L_3$ third decoding paths may be determined.

S403: Determine at least one reserved decoding path of the $i^{th}$ group of to-be-decoded bits from the $L_1 \times L_3$ third decoding paths, where
the at least one reserved decoding path includes a decoding result of the $i^{th}$ group of to-be-decoded bits.

Optionally, a quantity of the at least one reserved decoding path is less than or equal to X, where

X is a quantity that is of reserved decoding paths and that corresponds to successive cancellation list SCL decoding, and X is a positive integer.

For example, X may be 4, 8, or 6.

Certainly, in an actual application process, X may be set based on an actual requirement.

Optionally, the $L_1 \times L_3$ third decoding paths may be sorted based on path metric values of the $L_1 \times L_3$ third decoding paths, and the at least one reserved decoding path is selected from the $L_1 \times L_3$ sorted third decoding paths. For example, a smaller path metric value of a decoding path indicates a higher probability that the decoding path is a real decoding path. In this case, X decoding paths having smallest path metric values may be determined from the $L_1 \times L_3$ third decoding paths as the at least one reserved decoding path.

Optionally, when $L_1 \times L_3 < X$, all the $L_1 \times L_3$ third decoding paths may be determined as the reserved decoding paths.

In S402, the $L_2$ second decoding paths need to be sorted for $L_1$ times, and the $L_3$ third decoding paths are selected. Therefore, when a sorting method in which time complexity is $O(n^2)$ is used for sorting, sorting complexity in S402 is $L_1 \times L_2 \times L_3$.

In S403, the $L_1 \times L_3$ third decoding paths need to be sorted once, and the reserved decoding path is selected. In most decoding steps, X reserved decoding paths are usually selected. Therefore, when the sorting method in which time complexity is $O(n^2)$ is used for sorting, sorting complexity in S404 is $L_1 \times L_3 \times X$.

In conclusion, sorting complexity of the $i^{th}$-step decoding ($2 \leq i \leq P$) in this application is $L_1 \times L_2 \times L_3 + L_1 \times L_3 \times X$.

Sorting complexity of the $i^{th}$-step decoding ($2 \leq i \leq P$) in the prior art is usually $L_1 \times L_2 \times X$.

The sorting complexity in the prior art is usually greater than the sorting complexity in this application. Details are described as follows:

Because $L_1$ is usually equal to X, $L_2 = 2^n$, $L_3 = 2^{m-k}$, and m is usually equal to n, it can be learned that:

the sorting complexity in this application is $X \times 2^n \times 2^{n-k} + X \times 2^{n-k} \times X$; and
the sorting complexity in the prior art is $X \times 2^n \times X$, where

$$X \times 2^n \times X - X \times 2^n \times 2^{n-k} - X \times 2^{n-k} \times X = X \times 2^{n-k} \times \left[ X \times \left( 2^k - 1 \right) - 2^n \right].$$

In an actual application process, a value of k is properly set, so that $X \times (2^k - 1) > 2^n$. In this way, the sorting complexity in this application is lower than the sorting complexity in the prior art.

For example, it may be determined that k=n-2, and it is assumed that $X=2^a$. In this case, $2^a \times (2^{n-2} - 1) > 2^n$ provided that a>2, so that the sorting complexity in this application is lower than the sorting complexity in the prior art.

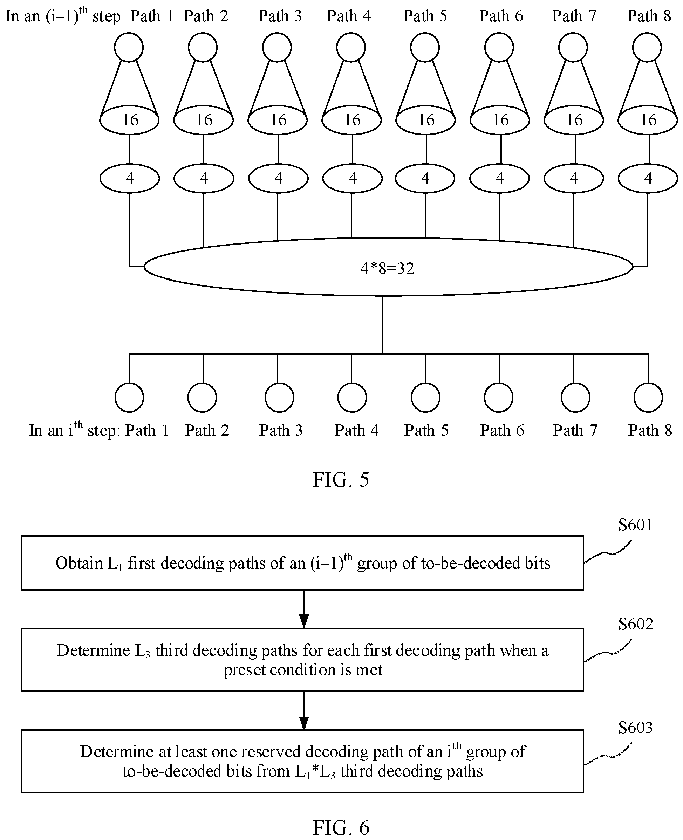

With reference to FIG. 5, the following describes, by using a specific example, the decoding process in the embodiment shown in FIG. 4.

FIG. 5 is a schematic diagram of an SCL parallel decoding process according to this application. Referring to FIG. 5, it is assumed that eight decoding paths are obtained in an $(i-1)^{th}$ step, and the eight decoding paths are respectively denoted as a path 1, a path 2, ..., and a path 8 in the $(i-1)^{th}$ step. Assuming that an $i^{th}$ group of to-be-decoded bits includes four to-be-decoded bits, in $i^{th}$-step decoding, for each decoding path in $(i-1)^{th}$-step decoding, 16 decoding paths may be obtained through extension. Assuming that $L_3$ is 4, four decoding paths are selected from the 16 decoding paths obtained by extending each decoding path, so that 4*8=32 decoding paths can be obtained. Then, the 32 decoding paths are sorted, and eight decoding paths in the $i^{th}$-step decoding are selected from the 32 sorted decoding paths. In the foregoing process, assuming that a sorting method in which time complexity is $O(n^2)$ is used for sorting, sorting complexity is: 16*4*8+32*8=768.

Compared with the prior art, in the prior art, in the $i^{th}$-step decoding, for each decoding path in the $(i-1)^{th}$-step decoding, 16 decoding paths may be obtained through extension, so that a total of 16*8=128 decoding paths can be obtained through extension. Then, the 128 decoding paths are sorted based on path metric values of the decoding paths, and eight decoding paths in the $i^{th}$-step decoding are selected from the 128 sorted decoding paths. In this case, sorting complexity is: 128*8=1024.

It can be learned from the foregoing that, compared with the prior art, in this application, the sorting complexity can be greatly reduced, thereby improving decoding efficiency.

According to the SCL parallel decoding method provided in this application, in any $i^{th}$-step decoding ($i \geq 2$) of SCL parallel decoding, the $L_1$ first decoding paths of the $(i-1)^{th}$ group of to-be-decoded bits are first obtained, and each first decoding path is extended, to obtain the $L_2$ second decoding paths corresponding to each first decoding path. When $L_2 > L_3$, the $L_3$ third decoding paths are selected from the $L_2$ second decoding paths corresponding to each first decoding path, to obtain the $L_1 \times L_3$ third decoding paths, and the at least one reserved decoding path is selected from the $L_1 \times L_3$ third decoding paths. In the foregoing process, the sorting complexity is reduced, thereby improving efficiency of the SCL parallel decoding method.

FIG. 6 is a schematic flowchart of yet another SCL parallel decoding method according to this application. An embodiment shown in FIG. 6 is a process of any $i^{th}$-step decoding ($1<i \leq P$) of SCL parallel decoding. Referring to FIG. 6, the method may include the following steps.

S601: Obtain $L_1$ first decoding paths of an $(i-1)^{th}$ group of to-be-decoded bits, where

received data corresponds to P groups of to-be-decoded bits, P is an integer greater than 1, i is an integer, $1<i \leq P$, and $L_1$ is a positive integer.

It should be noted that, for a process of performing S601, refer to S401. Details are not described herein again.

S602: Determine $L_3$ third decoding paths for each first decoding path when a preset condition is met, where

$L_1 \times L_3$ is greater than or equal to a first preset threshold, a quantity of information bits in an $i^{th}$ group of to-be-decoded bits is n, $L_3$ is a positive integer, and $L_3 < 2^n$.

Optionally, the preset condition is: $L_1 \times L_2$ is greater than the first preset threshold, where $L_2 = 2^n$.

Optionally, $L_3$ may be determined, and then the $L_3$ third decoding paths are determined for each first decoding path. Optionally, $L_3$ may be determined in at least the following two feasible implementations.

In a feasible implementation,

a preset parameter ($2^p$) is preset, and it is first determined whether a product of $L_1$ and the preset parameter is greater than or equal to the first preset threshold. If the product of $L_1$ and the preset parameter is greater than or equal to the first preset threshold, the preset parameter is determined as $L_3$. If the product of $L_1$ and the preset parameter is less than the first preset threshold, the preset parameter is updated. The updated preset parameter is determined as $L_3$ until the product of $L_1$ and the updated preset parameter is greater than or equal to the first preset threshold. For example, when the preset parameter is updated, p may be increased by 1 step by step.

In another feasible implementation,

it is determined that $L_3 = 2^{n-k}$, and a value of k is properly set, so that $L_1 \times L_3$ is greater than or equal to the first preset threshold.

Optionally, the $L_3$ third decoding paths may be determined for each first decoding path by performing the following step A and step B.

Step A: Determine $L_2$ second decoding paths for each first path, where $L_2 = 2^n$.

It should be noted that, for any first decoding path, $L_2$ second decoding paths corresponding to the first decoding path may be determined based on the first decoding path and the quantity n of information bits included in the i$^{th}$ group of to-be-decoded bits.

For example, assuming that a first decoding path is 0010, and n is 2, it may be determined that $L_2 = 2^2 = 4$ second decoding paths corresponding to the first decoding path 0010 include 001000, 001001, 001010, and 001011.

Step B: Determine the $L_3$ third decoding paths from the $L_2$ second decoding paths corresponding to each first decoding path.

Optionally, the $L_3$ third decoding paths are $L_3$ decoding paths having highest probabilities that the $L_2$ second decoding paths are real decoding paths.

Optionally, the $L_2$ second decoding paths may be sorted based on path metric values of the $L_2$ second decoding paths, and the $L_3$ third decoding paths are selected from the $L_2$ sorted second decoding paths.

For example, a smaller path metric value of a decoding path indicates a higher probability that the decoding path is a real decoding path. In this case, $L_3$ decoding paths having smallest path metric values may be determined from the $L_2$ second decoding paths as the $L_3$ third decoding paths.

Because the $L_3$ third decoding paths may be determined from the $L_2$ second decoding paths corresponding to each first decoding path, a total of $L_1 \times L_3$ third decoding paths may be determined.

S603: Determine at least one reserved decoding path of the i$^{th}$ group of to-be-decoded bits from the $L_1 \times L_3$ third decoding paths, where

the at least one reserved decoding path includes a decoding result of the i$^{th}$ group of to-be-decoded bits.

It should be noted that, for a process of performing S603, refer to the process of performing S403. Details are not described herein again.

It should be noted that sorting complexity shown in the embodiment shown in FIG. 6 is the same as the sorting complexity shown in FIG. 4. Therefore, the sorting complexity in this application is lower than the sorting complexity in the prior art.

According to the SCL parallel decoding method provided in this application, in any i$^{th}$-step decoding (i ≥ 2) of SCL parallel decoding, the $L_1$ first decoding paths of the (i-1)$^{th}$ group of to-be-decoded bits are first obtained, and each first decoding path is extended, to obtain the $L_2$ second decoding paths corresponding to each first decoding path. When $L_1 \times L_2$ is greater than the first preset threshold, the $L_3$ third decoding paths are determined for each first decoding path, to obtain the $L_1 \times L_3$ third decoding paths, and the at least one reserved decoding path is selected from the $L_1 \times L_3$ third decoding paths. In the foregoing process, the sorting complexity is reduced, thereby improving efficiency of the SCL parallel decoding method.

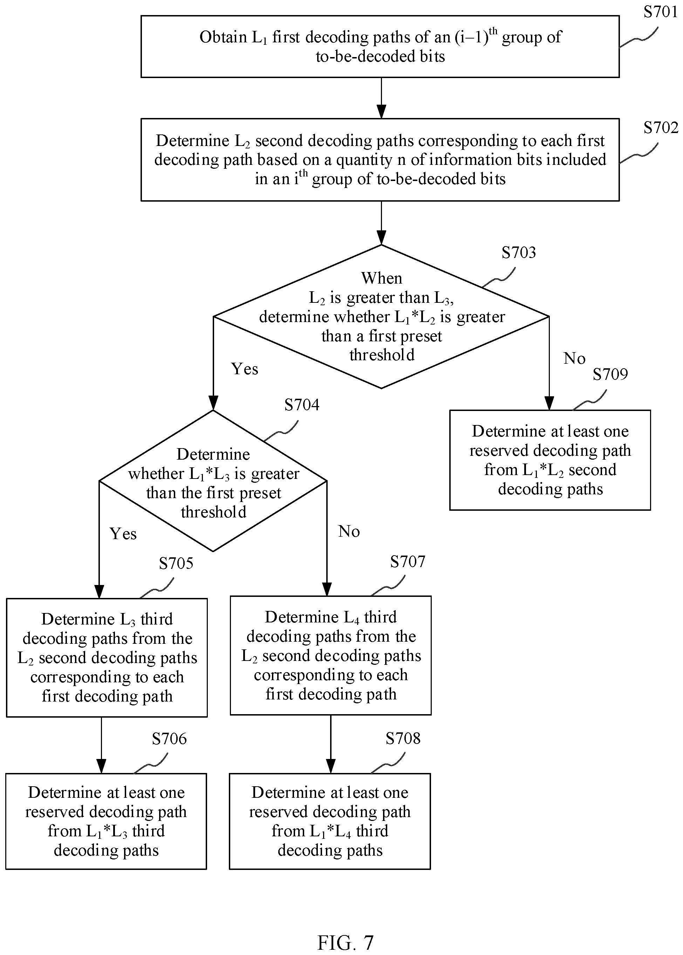

The following further describes the embodiment shown in FIG. 6 in detail by using an embodiment shown in FIG. 7.

FIG. 7 is a schematic flowchart of another SCL parallel decoding method according to this application. The embodiment shown in FIG. 7 is a process of any i$^{th}$-step decoding (1<i≤P) of SCL parallel decoding. Referring to FIG. 7, the method may include the following steps.

S701: Obtain $L_1$ first decoding paths of an (i-1)$^{th}$ group of to-be-decoded bits.

It should be noted that, for a process of performing S701, refer to the process of performing S401. Details are not described herein again in this application.

S702: Determine $L_2$ second decoding paths corresponding to each first decoding path based on a quantity n of information bits included in an i$^{th}$ group of to-be-decoded bits.

It should be noted that, for a process of performing S702, refer to the process of performing step A in the embodiment shown in FIG. 6. Details are not described herein again in this application.

S703: When $L_2 > L_3$, determine whether $L_1 \times L_2$ is greater than a first preset threshold.

If $L_1 \times L_2$ is greater than the first preset threshold, S704 to S708 are performed; or

if $L_1 \times L_2$ is less than or equal to the first preset threshold, S709 is performed.

Optionally, the first preset threshold is a minimum quantity of decoding paths included in a reserved decoding path set in one-step decoding. The reserved decoding path set is a decoding path set from which at least one reserved decoding path is selected.

For example, the first preset threshold may be any one of 2, 4, 8, 16, 32, 64, or 128.

Certainly, in an actual application process, the first preset threshold may be set based on an actual requirement. This is not specifically limited in this application.

S704: Determine whether $L_1 \times L_3$ is greater than the first preset threshold.

If $L_1 \times L_3$ is greater than the first preset threshold, S705 and S706 are performed; or

if $L_1 \times L_3$ is less than or equal to the first preset threshold, S707 and S708 are performed.

S705: Determine $L_3$ third decoding paths from the $L_2$ second decoding paths corresponding to each first decoding path.

It should be noted that, for a process of performing S705, refer to the process of performing step B in the embodiment shown in FIG. 6. Details are not described herein again in this application.

S706: Determine at least one reserved decoding path from $L_1 \times L_3$ third decoding paths.

It should be noted that, for a process of performing S706, refer to the process of performing S403. Details are not described herein again in this application.

S707: Determine $L_4$ third decoding paths from the $L_2$ second decoding paths corresponding to each first decoding path, where

$$L_3 < L_4 < L_2.$$

Optionally, in S707, $L_4$ may be first determined.

Optionally, assuming that $L_3 = 2^q$, because $L_2 = 2^n$, it may be determined that $L_4 = 2^t$, where $q < t < n$.

It should be noted that, for an execution process of determining the $L_4$ third decoding paths from the $L_2$ second decoding paths, refer to the process of determining the $L_3$ third decoding paths from the $L_2$ second decoding paths in step B in the embodiment shown in FIG. 6. Details are not described herein again.

S708: Determine at least one reserved decoding path from $L_1 \times L_4$ third decoding paths.

It should be noted that, for a process of performing S708, refer to the process of performing S403. Details are not described herein again in this application.

S709: Determine at least one reserved decoding path from $L_1 \times L_2$ second decoding paths.

It should be noted that, for a process of performing S709, refer to the process of performing S403. Details are not described herein again in this application.

In the embodiment shown in FIG. 7, in the $i^{th}$-step decoding, after the $L_1$ first decoding paths are obtained through $(i-1)^{th}$-step decoding and the $L_2$ second decoding paths corresponding to each first decoding path are determined, it is first determined whether $L_1 \times L_2$ is greater than the first preset threshold. When $L_1 \times L_2$ is greater than the first preset threshold, it indicates that $L_1 \times L_2$ is relatively large. To reduce sorting complexity, $L_3$ (less than $L_2$) or $L_4$ (less than $L_2$) third decoding paths are selected from the $L_2$ second decoding paths corresponding to each first decoding path, and at least one reserved path is determined from the plurality of third decoding paths. When $L_1 \times L_2$ is less than or equal to the first preset threshold, it indicates that $L_1 \times L_2$ is relatively small. To ensure decoding performance, at least one reserved path is directly selected from the $L_1 \times L_2$ second decoding paths.

With reference to FIG. 8A to FIG. 8D, the following describes in detail an SCL parallel decoding process.

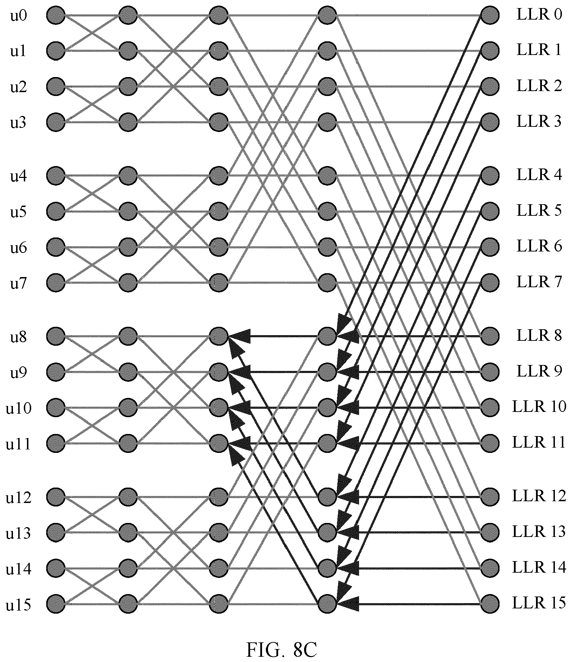

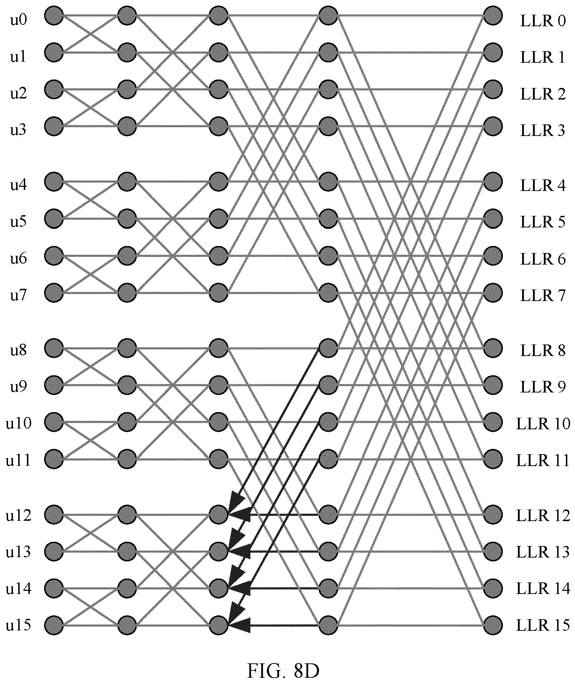

FIG. 8A is a schematic diagram of first-step decoding of SCL parallel decoding according to this application. FIG. 8B is a schematic diagram of second-step decoding of SCL parallel decoding according to this application. FIG. 8C is a schematic diagram of third-step decoding of SCL parallel decoding according to this application. FIG. 8D is a schematic diagram of fourth-step decoding of SCL parallel decoding according to this application.

Referring to FIG. 8A to FIG. 8D, a receive end receives 16 LLRs, and the 16 LLRs are respectively denoted as an LLR 0, an LLR 1, ..., and an LLR 15. Correspondingly, a quantity of to-be-decoded bits is 16, and the 16 to-be-decoded bits are respectively denoted as u0, u1, ..., and u15. The 16 to-be-decoded bits are divided into four groups, each group of to-be-decoded bits includes four to-be-decoded bits, and to-be-decoded bits included in the four groups of to-be-decoded bits are shown in Table 2.

Table 2

| | |
|---|---|
| First group of to-be-decoded bits | u0, u1, u2, and u3 |
| Second group of to-be-decoded bits | U4, u5, u6, and u7 |
| Third group of to-be-decoded bits | U8, u9, u10, and u11 |

(continued)

| Fourth group of to-be-decoded bits | U12, u13, u14, and u15 |
|---|---|

Referring to FIG. 8A to FIG. 8D, a polar code butterfly decoding network includes five columns of LLRs (or five layers of LLRs). The first column of LLRs from left to right are the first-layer LLRs; the second column of LLRs are the second-layer LLRs; and so on. The fifth column of LLRs are the fifth-layer LLRs.

Referring to FIG. 8A, in the first-step decoding, the third-layer LLRs of the first group of to-be-decoded bits (u0 to u3) are calculated based on the LLR 0, the LLR 1, ..., and the LLR 15. Then, LLRs of u0 to u3 are calculated in parallel by using an ML algorithm, a simplified SC algorithm, or the like, and a path metric value of each possible decoding path of the first group of to-be-decoded bits is calculated in parallel based on the LLRs of u0 to u3. Assuming that the first group of to-be-decoded bits includes four information bits, a quantity of all possible decoding paths of the first group of to-be-decoded bits is $2^4$, and all the possible decoding paths are respectively 000, 0001, 0010, 0011, 0100, 0101, 0110, 0111, 1000, 1001, 1010, 1011, 1100, 1101, 1110, and 1111. Assuming that a quantity of reserved decoding paths is 8, eight first decoding paths are selected from the 16 paths based on path metric values of the 16 decoding paths, and the eight first decoding paths are reserved decoding paths in the first-step decoding.

Referring to FIG. 8B, in the second-step decoding, the third-layer LLRs of the second group of to-be-decoded bits (u4 to u7) are calculated based on the LLR 0, the LLR 1, ..., and the LLR 15. Assuming that the second group of to-be-decoded bits includes four pieces of bit information, 16 second decoding paths may be obtained by extending each of the eight first decoding paths obtained through the first-step decoding. LLRs of u4 to u7 may be obtained through parallel calculation by using an ML algorithm or a simplified SC algorithm, and path metric values of the 16 second decoding paths corresponding to each first decoding path are calculated in parallel based on the LLRs of u4 to u7, that is, path metric values of 8*16=128 second decoding paths are obtained through parallel calculation. The 16 second decoding paths corresponding to each first decoding path may be sorted, and four third decoding paths are selected from the 16 second decoding paths corresponding to each first decoding path, so that 8*4=32 third decoding paths are obtained. The 32 third decoding paths are sorted, and eight reserved decoding paths are selected from the 32 sorted third decoding paths.

The third-step decoding and the fourth-step decoding are performed by using a method similar to that of the second-step decoding. After the fourth-step decoding, eight reserved decoding paths may be obtained, and one decoding path is selected from the eight fourth decoding paths as a decoding result.

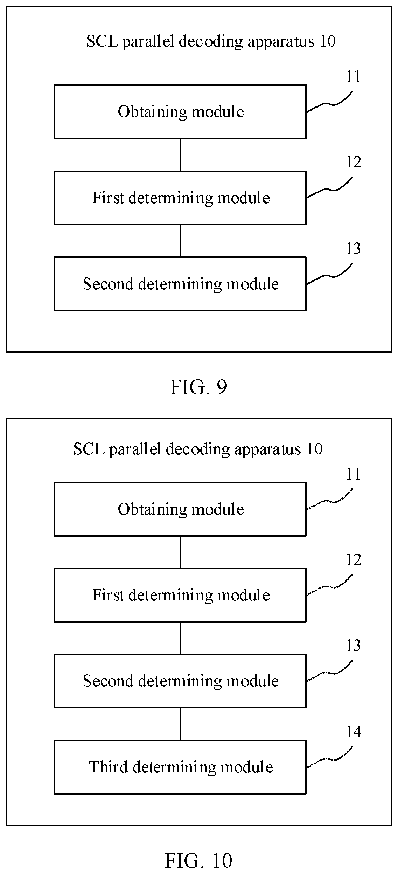

FIG. 9 is a schematic structural diagram of an SCL parallel decoding apparatus according to this application. The SCL parallel decoding apparatus may be disposed in a receiving device, and the receiving device may be a terminal device, a network device, or the like. Referring to FIG. 9, the SCL parallel decoding apparatus 10 may include an obtaining module 11, a first determining module 12, and a second determining module 13, where

the obtaining module 11 is configured to obtain $L_1$ first decoding paths of an $(i-1)^{th}$ group of to-be-decoded bits, where i is an integer, received data corresponds to P groups of to-be-decoded bits, P is an integer greater than 1, $1 < i \leq P$, and $L_1$ is a positive integer;

the first determining module 12 is configured to determine $L_3$ third decoding paths for each first decoding path, where a quantity of information bits in an $i^{th}$ group of to-be-decoded bits is n, n is a positive integer greater than or equal to 1, $L_3$ is a positive integer, and $L_3 < 2^n$; and

the second determining module 13 is configured to determine at least one reserved decoding path of the $i^{th}$ group of to-be-decoded bits from $L_1 \times L_3$ third decoding paths, where the at least one reserved decoding path includes a decoding result of the $i^{th}$ group of to-be-decoded bits.

Optionally, the obtaining module 11 may perform S401 in the embodiment shown in FIG. 4.

Optionally, the first determining module 12 may perform S402 in the embodiment shown in FIG. 4.

Optionally, the second determining module 13 may perform S403 in the embodiment shown in FIG. 4.

It should be noted that the SCL parallel decoding apparatus shown in this application may perform the technical solutions shown in the foregoing method embodiments. Implementation principles and beneficial effects of the SCL parallel decoding apparatus are similar to those of the technical solutions. Details are not described herein again.

In a possible implementation, the first determining module 12 is specifically configured to:

determine $L_2$ second decoding paths for each first decoding path, where $L_2 = 2^n$; and

determine the $L_3$ third decoding paths from the $L_2$ second decoding paths corresponding to each first decoding path.

In another possible implementation, $L_3 = 2^{m-k}$, where k is a positive integer, m is a quantity of to-be-decoded bits included in each group of to-be-decoded bits, m is an integer greater than 1, and $1 \le k < m$.

In another possible implementation, $L_3$ is any one of 2, 4, 8, 16, 32, or 64.

FIG. 10 is a schematic structural diagram of another SCL parallel decoding apparatus according to this application. Based on the embodiment shown in FIG. 9, referring to FIG. 10, the SCL parallel decoding apparatus 10 further includes a third determining module 14, where

the third determining module 14 is configured to: when i=P, determine, from the at least one reserved decoding path, a decoding path having a highest accuracy rate, and determine a decoding result of the P groups of to-be-decoded bits based on the decoding path.

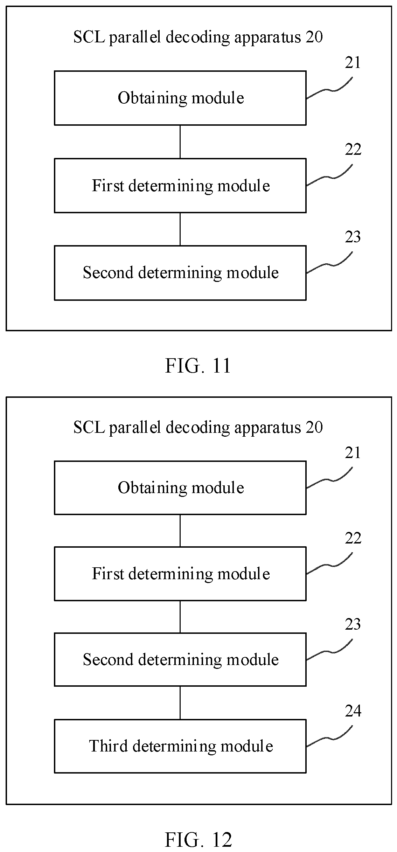

It should be noted that the SCL parallel decoding apparatus shown in this application may perform the technical solutions shown in the foregoing method embodiments. Implementation principles and beneficial effects of the SCL parallel decoding apparatus are similar to those of the technical solutions. Details are not described herein again. FIG. 11 is a schematic structural diagram of still another SCL parallel decoding apparatus according to this application. The SCL parallel decoding apparatus may be disposed in a receiving device, and the receiving device may be a terminal device, a network device, or the like. Referring to FIG. 11, the SCL parallel decoding apparatus 20 may include an obtaining module 21, a first determining module 22, and a second determining module 23, where

the obtaining module 21 is configured to obtain $L_1$ first decoding paths of an $(i-1)^{th}$ group of to-be-decoded bits, where i is an integer, P is an integer greater than 1, received data corresponds to P groups of to-be-decoded bits, $1 < i \le P$, and $L_1$ is a positive integer;

the first determining module 22 is configured to determine $L_3$ third decoding paths for each first decoding path when a preset condition is met, where $L_1 \times L_3$ is greater than or equal to a first preset threshold, a quantity of information bits in an $i^{th}$ group of to-be-decoded bits is n, n is a positive integer greater than or equal to 1, $L_3$ is a positive integer, and $L_3 < 2^n$; and

the second determining module 23 is configured to determine at least one reserved decoding path of the $i^{th}$ group of to-be-decoded bits from $L_1 \times L_3$ third decoding paths, where the at least one reserved decoding path includes a decoding result of the $i^{th}$ group of to-be-decoded bits.

Optionally, the obtaining module 21 may perform S601 in the embodiment shown in FIG. 6 and S701 in the embodiment shown in FIG. 7.

Optionally, the first determining module 22 may perform S602 in the embodiment shown in FIG. 6 and S702 to S705 and S707 in the embodiment shown in FIG. 7.

Optionally, the second determining module 23 may perform S603 in the embodiment shown in FIG. 6 and S706, S708, and S709 in the embodiment shown in FIG. 7.

It should be noted that the SCL parallel decoding apparatus shown in this application may perform the technical solutions shown in the foregoing method embodiments. Implementation principles and beneficial effects of the SCL parallel decoding apparatus are similar to those of the technical solutions. Details are not described herein again.

In another possible implementation, the first determining module 22 is specifically configured to:

determine $L_2$ second decoding paths for each first path, where $L_2 = 2^n$; and

determine the $L_3$ third decoding paths from the $L_2$ second decoding paths corresponding to each first decoding path.

In another possible implementation, the preset condition is:
$L_1 \times L_2$ is greater than the first preset threshold.

In another possible implementation, the first preset threshold is any one of 2, 4, 8, 16, 32, 64, or 128.

In another possible implementation, if $L_1 \times 2^{m-k}$ is greater than or equal to the first preset threshold, $L_3 = 2^{m-k}$, where k is a positive integer, m is a quantity of to-be-decoded bits included in each group of to-be-decoded bits, m is an integer greater than 1, and $1 \le k < m$.

In another possible implementation, $L_3$ is any one of 2, 4, 8, 16, 32, or 64.

FIG. 12 is a schematic structural diagram of another SCL parallel decoding apparatus according to this application. Based on the embodiment shown in FIG. 11, referring to FIG. 12, the SCL parallel decoding apparatus 20 further includes a third determining module 24, where

the third determining module 24 is configured to: when i=P, determine, from the at least one reserved decoding path, a decoding path having a highest accuracy rate, and determine a decoding result of the P groups of to-be-decoded bits based on the decoding path.

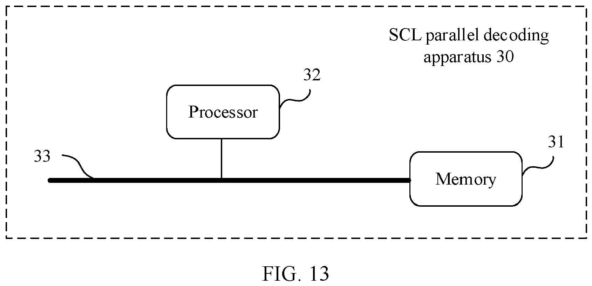

It should be noted that the SCL parallel decoding apparatus shown in this application may perform the technical solutions shown in the foregoing method embodiments. Implementation principles and beneficial effects of the SCL parallel decoding apparatus are similar to those of the technical solutions. Details are not described herein again. FIG. 13 is a schematic structural diagram of hardware of an SCL parallel decoding apparatus according to this application.

Referring to FIG. 13, the SCL parallel decoding apparatus 30 includes a memory 31 and a processor 32, where the memory 31 communicates with the processor 32. For example, the memory 31 communicates with the processor 32 by using a communications bus 33. The memory 31 is configured to store a computer program, and the processor 32 executes the computer program to implement the method shown in the foregoing embodiments.

Optionally, the SCL parallel decoding apparatus may further include a transmitter and/or a receiver.

Optionally, the processor may be a central processing unit (Central Processing Unit, CPU), or may be another general purpose processor, a digital signal processor (Digital Signal Processor, DSP), an application-specific integrated circuit (Application Specific Integrated Circuit, ASIC), or the like. The general purpose processor may be a microprocessor, or the processor may be any conventional processor or the like. The steps (S201 to S203 in the embodiment shown in FIG. 2, S301 to S303 in the embodiment shown in FIG. 3, S401 to S403 in the embodiment shown in FIG. 4, S601 to S603 in the embodiment shown in FIG. 6, and S701 to S709 in the embodiment shown in FIG. 7) of the method disclosed in this application may be directly performed and completed by a hardware processor, or may be performed and completed through a combination of hardware in the processor and a software module.

This application provides a computer-readable storage medium. The computer-readable storage medium includes an instruction. When the instruction is run on a computer, the computer is enabled to perform the SCL parallel decoding method provided in any one of the foregoing method embodiments.

This application provides a chip. The chip is configured to support a receiving device (for example, a terminal device or a network device) in implementing a function (for example, obtaining a first decoding path, determining a second decoding path, determining a third decoding path, and determining a reserved decoding path) in the embodiments of this application. The chip is specifically used in a chip system. The chip system may include the chip, or may include the chip and another discrete device. When the chip in the receiving device implements the foregoing method, the chip includes a processing unit. Further, the chip may further include a communications unit. The processing unit may be, for example, a processor. When the chip includes the communications unit, the communications unit may be, for example, an input/output interface, a pin, or a circuit. The processing unit performs all or some actions performed by processing modules (for example, the obtaining module, the first determining module, the second determining module, and the third determining module in FIG. 9 to FIG. 12) in the embodiments of this application. The communications unit may perform a corresponding receiving or sending action, for example, receive to-be-decoded bits before the obtaining module obtains $L_1$ first decoding paths of an $(i-1)^{th}$ group of to-be-decoded bits. In another specific embodiment, the processing module of the receiving device in this application may be the processing unit of the chip, and a receiving module or a sending module of a control device may be the communications unit of the chip.

All or some of the steps of the method embodiments may be implemented by hardware related to a program instruction. The foregoing program may be stored in a readable memory. When the program is executed, the steps in the foregoing method embodiments are performed. The foregoing memory (storage medium) includes: a read-only memory (English: read-only memory, ROM for short), a RAM, a flash memory, a hard disk, a solid-state drive, a magnetic tape (English: magnetic tape), a floppy disk (English: floppy disk), an optical disc (English: optical disc), and any combination thereof.

The embodiments of this application are described with reference to the flowcharts and/or block diagrams of the method, the device (system), and the computer program product according to the embodiments of this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a special-purpose computer, an embedded processor, or a processing unit of another programmable data processing device to generate a machine, so that instructions executed by the computer or the processing unit of the another programmable data processing device generate an apparatus for implementing a specified function in one or more processes in the flowcharts and/or in one or more blocks in the block diagrams.

These computer program instructions may alternatively be stored in a computer-readable memory that can instruct a computer or another programmable data processing device to work in a specific manner, so that the instructions stored in the computer-readable memory generate an artifact that includes an instruction apparatus. The instruction apparatus implements a specified function in one or more processes in the flowcharts and/or in one or more blocks in the block diagrams.

The computer program instructions may alternatively be loaded onto a computer or another programmable data processing device, so that a series of operations and steps are performed on the computer or another programmable device, thereby generating computer-implemented processing. Therefore, the instructions executed on the computer or the another programmable device provide steps for implementing a specified function in one or more processes in the flowcharts and/or in one or more blocks in the block diagrams.

Apparently, a person skilled in the art can make various modifications and variations to the embodiments of this application without departing from the spirit and scope of this application. This application is intended to cover these modifications and variations provided that they fall within the scope of protection defined by the following claims and their equivalent technologies.

In this application, the term "including" and a variant thereof may refer to non-limitative inclusion; and the term "or" and a variant thereof may refer to "and/or". In this application, the terms "first", "second", and the like are intended to distinguish between similar objects but do not necessarily indicate a specific order or sequence. In this application, "a plurality of" means two or more than two. The term "and/or" describes an association relationship for describing associated objects and represents that three relationships may exist. For example, A and/or B may represent the following three cases: Only A exists, both A and B exist, and only B exists. The character "/" generally indicates an "or" relationship between the associated objects.

**Claims**

1. A successive cancellation list SCL parallel decoding method, wherein received data corresponds to P groups of to-be-decoded bits, and the method comprises:

   obtaining $L_1$ first decoding paths of an $(i-1)^{th}$ group of to-be-decoded bits, wherein i is an integer, P is an integer greater than 1, $1 < i \leq P$, and $L_1$ is a positive integer;
   determining $L_3$ third decoding paths for each first decoding path, wherein a quantity of information bits in an $i^{th}$ group of to-be-decoded bits is n, n is a positive integer greater than or equal to 1, $L_3$ is a positive integer, and $L_3 < 2^n$; and
   determining at least one reserved decoding path of the $i^{th}$ group of to-be-decoded bits from $L_1 \times L_3$ third decoding paths, wherein the at least one reserved decoding path comprises a decoding result of the $i^{th}$ group of to-be-decoded bits.

2. The method according to claim 1, wherein the determining $L_3$ third decoding paths for each first decoding path comprises:

   determining $L_2$ second decoding paths for each first decoding path, wherein $L_2 = 2^n$; and
   determining the $L_3$ third decoding paths from the $L_2$ second decoding paths corresponding to each first decoding path.

3. The method according to claim 1 or 2, wherein
   $L_3 = 2^{m-k}$, wherein k is a positive integer, m is a quantity of to-be-decoded bits comprised in each group of to-be-decoded bits, m is an integer greater than 1, and $1 \leq k < m$.

4. The method according to any one of claims 1 to 3, wherein $L_3$ is any one of 2, 4, 8, 16, 32, or 64.

5. A successive cancellation list SCL parallel decoding method, wherein received data corresponds to P groups of to-be-decoded bits, and the method comprises:

   obtaining $L_1$ first decoding paths of an $(i-1)^{th}$ group of to-be-decoded bits, wherein i is an integer, P is an integer greater than 1, $1 < i \leq P$, and $L_1$ is a positive integer;
   determining $L_3$ third decoding paths for each first decoding path when a preset condition is met, wherein $L_1 \times L_3$ is greater than or equal to a first preset threshold, a quantity of information bits in an $i^{th}$ group of to-be-decoded bits is n, n is a positive integer greater than or equal to 1, $L_3$ is a positive integer, and $L_3 < 2^n$; and
   determining at least one reserved decoding path of the $i^{th}$ group of to-be-decoded bits from $L_1 \times L_3$ third decoding paths, wherein the at least one reserved decoding path comprises a decoding result of the $i^{th}$ group of to-be-decoded bits.

6. The method according to claim 5, wherein the determining L3 third paths for each first path comprises:

   determining $L_2$ second decoding paths for each first path, wherein $L_2 = 2^n$; and
   determining the $L_3$ third decoding paths from the $L_2$ second decoding paths corresponding to each first decoding path.

7. The method according to claim 5 or 6, wherein the preset condition is:
   $L_1 \times L_2$ is greater than the first preset threshold.

8. The method according to any one of claims 5 to 7, wherein the first preset threshold is any one of 2, 4, 8, 16, 32, 64, or 128.

9. The method according to any one of claims 5 to 7, wherein
if $L_1 \times 2^{m-k}$ is greater than or equal to the first preset threshold, $L_3 = 2^{m-k}$, wherein k is a positive integer, m is a quantity of to-be-decoded bits comprised in each group of to-be-decoded bits, m is an integer greater than 1, and $1 \leq k < m$.

10. The method according to any one of claims 5 to 7, wherein $L_3$ is any one of 2, 4, 8, 16, 32, or 64.

11. The method according to any one of claims 5 to 10, wherein when i=P, the method further comprises:

determining, from the at least one reserved decoding path, a decoding path having a highest accuracy rate; and
determining a decoding result of the P groups of to-be-decoded bits based on the decoding path.

12. A successive cancellation list SCL parallel decoding apparatus, wherein received data corresponds to P groups of to-be-decoded bits, and the apparatus comprises an obtaining module, a first determining module, and a second determining module, wherein
the obtaining module is configured to obtain $L_1$ first decoding paths of an $(i-1)^{th}$ group of to-be-decoded bits, wherein i is an integer, P is an integer greater than 1, $1 < i \leq P$, and $L_1$ is a positive integer;
the first determining module is configured to determine $L_3$ third decoding paths for each first decoding path, wherein a quantity of information bits in an $i^{th}$ group of to-be-decoded bits is n, n is a positive integer greater than or equal to 1, $L_3$ is a positive integer, and $L_3 < 2^n$; and
the second determining module is configured to determine at least one reserved decoding path of the $i^{th}$ group of to-be-decoded bits from $L_1 \times L_3$ third decoding paths, wherein the at least one reserved decoding path comprises a decoding result of the $i^{th}$ group of to-be-decoded bits.

13. The apparatus according to claim 12, wherein the first determining module is specifically configured to:

determine $L_2$ second decoding paths for each first decoding path, wherein $L_2 = 2^n$; and
determine the $L_3$ third decoding paths from the $L_2$ second decoding paths corresponding to each first decoding path.

14. The apparatus according to claim 12 or 13, wherein
$L_3 = 2^{m-k}$, wherein k is a positive integer, m is a quantity of to-be-decoded bits comprised in each group of to-be-decoded bits, m is an integer greater than 1, and $1 \leq k < m$.

15. The apparatus according to any one of claims 12 to 14, wherein $L_3$ is any one of 2, 4, 8, 16, 32, or 64.

16. A successive cancellation list SCL parallel decoding apparatus, wherein received data corresponds to P groups of to-be-decoded bits, and the apparatus comprises an obtaining module, a first determining module, and a second determining module, wherein
the obtaining module is configured to obtain $L_1$ first decoding paths of an $(i-1)^{th}$ group of to-be-decoded bits, wherein i is an integer, P is an integer greater than 1, $1 < i \leq P$, and $L_1$ is a positive integer;
the first determining module is configured to determine $L_3$ third decoding paths for each first decoding path when a preset condition is met, wherein $L_1 \times L_3$ is greater than or equal to a first preset threshold, a quantity of information bits in an $i^{th}$ group of to-be-decoded bits is n, n is a positive integer greater than or equal to 1, $L_3$ is a positive integer, and $L_3 < 2^n$; and
the second determining module is configured to determine at least one reserved decoding path of the $i^{th}$ group of to-be-decoded bits from $L_1 \times L_3$ third decoding paths, wherein the at least one reserved decoding path comprises a decoding result of the $i^{th}$ group of to-be-decoded bits.

17. The apparatus according to claim 16, wherein the first determining module is specifically configured to:

determine $L_2$ second decoding paths for each first path, wherein $L_2 = 2^n$; and
determine the $L_3$ third decoding paths from the $L_2$ second decoding paths corresponding to each first decoding path.

**18.** The apparatus according to claim 16 or 17, wherein the preset condition is:
$L_1 \times L_2$ is greater than the first preset threshold.

**19.** The apparatus according to any one of claims 16 to 18, wherein the first preset threshold is any one of 2, 4, 8, 16, 32, 64, or 128.

**20.** The apparatus according to any one of claims 16 to 18, wherein
if $L_1 \times 2^{m-k}$ is greater than or equal to the first preset threshold, $L_3 = 2^{m-k}$, wherein k is a positive integer, m is a quantity of to-be-decoded bits comprised in each group of to-be-decoded bits, m is an integer greater than 1, and $1 \leq k < m$.

**21.** The apparatus according to any one of claims 16 to 18, wherein $L_3$ is any one of 2, 4, 8, 16, 32, or 64.

**22.** The apparatus according to any one of claims 16 to 21, wherein the apparatus further comprises a third determining module, wherein
the third determining module is configured to: when i=P, determine, from the at least one reserved decoding path, a decoding path having a highest accuracy rate, and determine a decoding result of the P groups of to-be-decoded bits based on the decoding path.

**23.** An SCL parallel decoding apparatus, comprising a memory and a processor, wherein the processor executes a program instruction in the memory, to implement the SCL parallel decoding method according to any one of claims 1 to 4.

**24.** An SCL parallel decoding apparatus, comprising a memory and a processor, wherein the processor executes a program instruction in the memory, to implement the SCL parallel decoding method according to any one of claims 5 to 11.

**25.** A storage medium, wherein the storage medium is configured to store a computer program, and the computer program is used to implement the SCL parallel decoding method according to any one of claims 1 to 4.

**26.** A storage medium, wherein the storage medium is configured to store a computer program, and the computer program is used to implement the SCL parallel decoding method according to any one of claims 5 to 11.

FIG. 1

| S201 |
| --- |
| Receive $2^a$ LLRs |

| S202 |
| --- |
| Divide $2^a$ to-be-decoded bits into P groups of to-be-decoded bits |

| S203 |
| --- |
| Perform P-step decoding based on the $2^a$ LLRs by using the P groups of to-be-decoded bits as decoding objects, until a decoding result is obtained |

FIG. 2

Second-step
decoding

Third-step
decoding

FIG. 2A

Calculate an $(m+1)^{th}$-layer LLR of each to-be-decoded information bit in the first group of to-be-decoded bits based on $2^a$ LLRs

S301

Calculate, in parallel based on the $(m+1)^{th}$-layer LLR of each to-be-decoded information bit in the first group of to-be-decoded bits, path metric values of all possible decoding paths in first-step decoding

S302

Determine, based on the path metric values of all the possible decoding paths in the first-step decoding, at least one reserved decoding path in the first-step decoding from all the possible decoding paths in the first-step decoding

S303

FIG. 3

Obtain $L_1$ first decoding paths of an $(i-1)^{th}$ group of to-be-decoded bits

S401

Determine $L_3$ third decoding paths for each first decoding path

S402

Determine at least one reserved decoding path from $L_1*L_3$ third decoding paths

S403

FIG. 4

In an (i–1)$^{th}$ step: Path 1  Path 2    Path 3    Path 4    Path 5    Path 6    Path 7    Path 8

4*8=32

In an i$^{th}$ step: Path 1   Path 2    Path 3    Path 4    Path 5    Path 6    Path 7    Path 8

FIG. 5

S601

Obtain L$_1$ first decoding paths of an (i–1)$^{th}$ group of to-be-decoded bits

S602

Determine L$_3$ third decoding paths for each first decoding path when a preset condition is met

S603

Determine at least one reserved decoding path of an i$^{th}$ group of to-be-decoded bits from L$_1$*L$_3$ third decoding paths

FIG. 6

Obtain $L_1$ first decoding paths of an $(i-1)^{th}$ group of to-be-decoded bits

S701

Determine $L_2$ second decoding paths corresponding to each first decoding path based on a quantity n of information bits included in an $i^{th}$ group of to-be-decoded bits

S702

When $L_2$ is greater than $L_3$, determine whether $L_1*L_2$ is greater than a first preset threshold

S703

Yes

No

S709

Determine whether $L_1*L_3$ is greater than the first preset threshold

S704

Determine at least one reserved decoding path from $L_1*L_2$ second decoding paths

Yes

No

S705

Determine $L_3$ third decoding paths from the $L_2$ second decoding paths corresponding to each first decoding path

S707

Determine $L_4$ third decoding paths from the $L_2$ second decoding paths corresponding to each first decoding path

S706

Determine at least one reserved decoding path from $L_1*L_3$ third decoding paths

S708

Determine at least one reserved decoding path from $L_1*L_4$ third decoding paths

FIG. 7

FIG. 8A

FIG. 8B

u0
u1
u2
u3
u4
u5
u6
u7
u8
u9
u10
u11
u12
u13
u14
u15

LLR 0
LLR 1
LLR 2
LLR 3
LLR 4
LLR 5
LLR 6
LLR 7
LLR 8
LLR 9
LLR 10
LLR 11
LLR 12
LLR 13
LLR 14
LLR 15

FIG. 8C

FIG. 8D

FIG. 9

FIG. 10

SCL parallel decoding apparatus 20

Obtaining module 21

First determining module 22

Second determining module 23

FIG. 11

SCL parallel decoding apparatus 20

Obtaining module 21

First determining module 22

Second determining module 23

Third determining module 24

FIG. 12

SCL parallel decoding
apparatus 30

32
Processor

33
Memory
31

FIG. 13

## INTERNATIONAL SEARCH REPORT

| | International application No. |
|---|---|
| | **PCT/CN2018/103293** |

**A.    CLASSIFICATION OF SUBJECT MATTER**

H04L 1/00(2006.01)i;  H03M 13/09(2006.01)i

According to International Patent Classification (IPC) or to both national classification and IPC

**B.    FIELDS SEARCHED**

Minimum documentation searched (classification system followed by classification symbols)

H04L; H03M

Documentation searched other than minimum documentation to the extent that such documents are included in the fields searched

Electronic data base consulted during the international search (name of data base and, where practicable, search terms used)

WPI, EPODOC, CNPAT, CNKI, IEEE: 串行抵消列表, 连续抵消列表, 极化码, 并行, 译码, 路径, SCL, polar, parallel, code, route, path

**C.    DOCUMENTS CONSIDERED TO BE RELEVANT**

| Category* | Citation of document, with indication, where appropriate, of the relevant passages | Relevant to claim No. |
|---|---|---|
| A | CN 106487479 A (GRADUATE SCHOOL AT SHENZHEN, TSINGHUA UNIVERSITY) 08 March 2017 (2017-03-08) <br> description, paragraphs [0059]-[0104] | 1-26 |
| A | CN 104124979 A (HUAWEI TECHNOLOGIES CO., LTD.) 29 October 2014 (2014-10-29) <br> entire document | 1-26 |
| A | CN 108063649 A (SOUTHEAST UNIVERSITY) 22 May 2018 (2018-05-22) <br> entire document | 1-26 |
| A | CN 107896137 A (SOUTHEAST UNIVERSITY) 10 April 2018 (2018-04-10) <br> entire document | 1-26 |
| A | US 2013117344 A1 (GROSS, WARREN ET AL.) 09 May 2013 (2013-05-09) <br> entire document | 1-26 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **14 May 2019** | **29 May 2019** |

| Name and mailing address of the ISA/CN | Authorized officer |
|---|---|
| **China National Intellectual Property Administration (ISA/ CN)** <br> **No. 6, Xitucheng Road, Jimenqiao, Haidian District, Beijing 100088** <br> **China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2018/103293**

| Patent document cited in search report | | | Publication date (day/month/year) | Patent family member(s) | | | Publication date (day/month/year) |
|---|---|---|---|---|---|---|---|
| CN | 106487479 | A | 08 March 2017 | None | | | |
| CN | 104124979 | A | 29 October 2014 | WO | 2014173133 | A1 | 30 October 2014 |
| CN | 108063649 | A | 22 May 2018 | None | | | |
| CN | 107896137 | A | 10 April 2018 | None | | | |
| US | 2013117344 | A1 | 09 May 2013 | US | 2016056843 | A1 | 25 February 2016 |

Form PCT/ISA/210 (patent family annex) (January 2015)